**Europäisches Patentamt**

**European Patent Office**

**Office européen des brevets**

(11) Veröffentlichungsnummer: **0 002 434**
**A1**

## EUROPÄISCHE PATENTANMELDUNG

(21) Anmeldenummer: **78100948.5**

(22) Anmeldetag: **21.09.78**

(51) Int. Cl.²: **H 03 J 1/18**
**G 08 C 23/00**
**//G06F3/02**

(30) Priorität: 30.09.77 DE 2744057
14.12.77 DE 2755596

(43) Veröffentlichungstag der Anmeldung:
27.06.79 Patentblatt 79/13

(84) Benannte Vertragsstaaten:
BE CH DE FR GB NL SE

(71) Anmelder: LOEWE OPTA GMBH
Industriestrasse 11 Postfach 220
D-8640 Kronach(DE)

(72) Erfinder: Ruppertsberg, Siegfried R.
Weinstrasse 1
D-8630 Coburg(DE)

(54) **Fernsteuerung zum Steuern, Ein- und Umschalten von variablen und festen Gerätefunktionen und Funktionsgrössen in nachrichtentechnischen Geräten.**

(57) Bei drahtlosen und drahtgebundenen Fernsteuerungen von nachrichtentechnischen Geräten, wie Fernseh- und Rundfunk-empfangsgeräte, werden die Stellinformationen bei Betätigung entsprechender Funktionstasten (21) durch eine Sendestufe (23, 32) übertragen und im zu steuernden Gerät empfangen und nach Demodulation den Funktionsstellern zugeführt. Die Anzahl der zu steuernden Funktionen ist auf die Anzahl der maximal zur Verfügung stehenden Tasten (21) beschränkt.

Zum Zwecke des erweiterten Einsatzes einer Fernsteuerung und mit möglichst wenigen Tastaturen eine Vielzahl von Funktionen steuern zu können, werden die Steuerbefehle in einen im Fernbedienungsgeber integrierten Computer (22) eingegeben und von diesem durch eingeschriebene Programme in Stellinformationen umgerechnet, die über die Sendestufe (23, 32) an den Empfänger übertragen werden. Mit Hilfe von einlesbaren Programmträgern (31) lässt sich der Computer (22) für verschiedene Signalauswertugen programmieren.

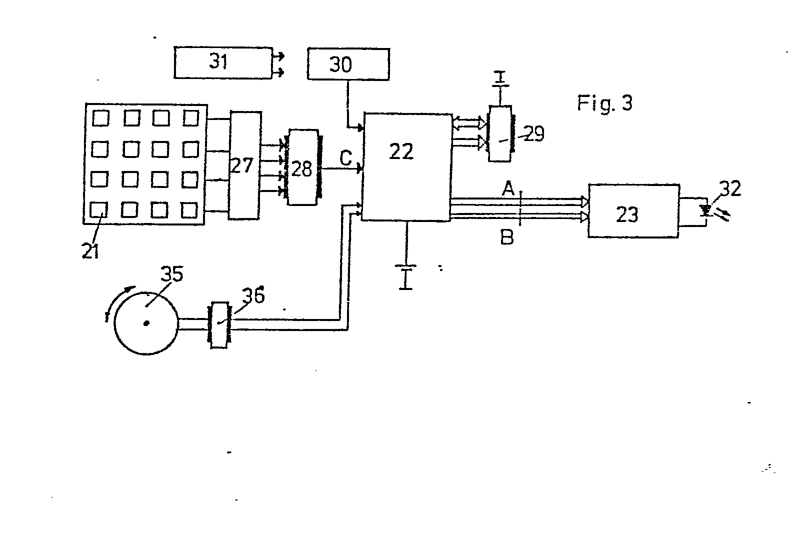

EP 0 002 434 A1

../...

Fig. 3

Fernsteuerung zum Steuern, Ein- und Umschalten von
variablen und festen Gerätefunktionen und Funktionsgrößen in nachrichtentechnischen Geräten


Die Erfindung betrifft eine Fernsteuerung nach dem
Oberbegriff des Anspruches 1.

Fernsteuerungen kommen in der modernen Unterhaltungselektronik immer mehr zur Anwendung. Vorwiegend werden
derartige Fernsteuerungen in Verbindung mit Fernsehempfangsgeräten eingesetzt, um dem Zuschauer beim Fernsehen
eine Anpassung der variablen Gerätefunktionen, wie Lautstärke, Bildhelligkeit, Kontrast und dergl., sowie eine
Kanalumschaltung nach den individuellen Wünschen zu
ermöglichen, ohne daß die Funktionen direkt am Fernsehapparat eingestellt werden müssen. Darüber hinaus werden
auch andere Funktionen in einem Fernsehgerät über Fernbedienungen, die die Befehlssignale drahtlos oder drahtgebunden übertragen können, gesteuert. Z.B. ist es bei
Fernsehgeräten mit Fernsehspielschaltung üblich, die
Funktionen der Fernsehspielschaltung über eine drahtgebundene Fernbedienung zu betätigen. Es ist auch vorgeschlagen worden, diese Bedienung drahtlos zu ermöglichen,
um ortsunabhängiger zum Fernsehgerät hin sein zu können.

- 2 -

Die Weiterentwicklung von Fernsehgeräten hat auch neue
Einsatzmöglichkeiten erschlossen, z.B. werden teils im
Versuch und teils auch bereits kommerziell Texte und
Informationen von zentralen Datenbanken übertragen und
durch Abruf auf dem Fernsehschirm sichtbar (Teletext,
Viewdata usw.), der dann die Funktion eines Monitors
übernimmt. Um den Bedienungskomfort solcher Geräte ebenfalls
dem derzeitigen Standard anzupassen, sind die Fernbedienungsgeber in der Regel auch mit zusätzlichen Tasten für derartige
Zwecke versehen.

Zur Erhöhung des Bedienungskomforts von Rundfunkempfangsgeräten, insbesondere Hifi-Geräten, ist es ebenfalls bereits
bekannt, Fernbedienungen einzusetzen, um dem Zuhörer eine
individuelle Anpassung der variablen Größen, wie Lautstärke,
Bässe, Höhen, Balance und dergl., an jedem Ort eines Raumes
zu ermöglichen, wobei die Klanganpassung aus räumlichen
Gründen stets individuell erfolgen muß.

Moderne Übertragungsverfahren bei drahtlosen und drahtgebundenen Fernbedienungen gestatten die serielle Steuerung
einer Vielzahl von Funktionen. Es ist z.B. bei einem
bekannten Fernsteuersystem möglich, mit ein und derselben
Fernbedienung ca. 60 Funktionen zu steuern, so daß die
Fernbedienung sowohl für die Ansteuerung eines Fernsehgerätes
als auch zur gleichzeitigen Ansteuerung eines Rundfunkempfangsgerätes oder anderer im Sende/Empfangsbereich der
Fernsteuerung angeordneter fernsteuerbarer Geräte mit
gleichem Übertragungssystem, wie Raumlichtsteuerung,
Verdunklungen und dergl., verwendet werden kann. Der
Erweiterung der Funktionssteuerungen durch digitale
Techniken und digitale Übertragungstechniken für mannigfaltige Anwendungen sind dabei praktisch keine Grenzen

- 3 -

gesetzt, da auch auf der Empfangsseite der Fernbedienung
mittels moderner Computertechnik eine weitergehende
Ausnutzung einzelner übertragener Signale durch Befehlsumschaltung erfolgen kann, z.B. die Ausnutzung des Fernsehgerätes als Monitor für einen Rechner, wobei die Fernbedienung die Rechnertastatur beinhaltet. Um die Funktionen
steuern zu können, muß der Fernbedienungsgeber neben der
Vielzahl von Übertragungskanälen, Codierstufen und dergl.
über eine entsprechende Anzahl von Funktionssteuertasten
verfügen. Zieht man in Betracht, daß für jede zu steuernde
variable Funktion mindestens zwei Tasten bzw. Sensoren oder
andere Stellglieder (+, -) notwendig sind und allein bei einem
Fernsehgerät in der Regel drei bis vier variable Gerätefunktionen gesteuert werden, bei Hifi-Geräten noch mehr, so ist
es verständlich, daß eine Fernbedienung, die einen vielseitigen Bedienungskomfort ermöglichen soll, eine Vielzahl
von Stellgliedern, Tasten, Sensoren und dergl. aufweisen
muß, die eine übersichtliche, handliche Bedienung nicht mehr
gewährleisten. Hinzu kommt, daß bei Umschalten auf einzelne
Funktionen in manchen Fällen im Empfänger vorbereitende
Funktionen ausgelöst werden müssen, die zusätzliche Tasten
notwendig machen, z.B. zum Empfang von Teletext oder Viewdata,
die eine Reihe von Funktionsbetätigungen erforderlich machen,
damit die auszuschließende externe Datenbank auch tatsächlich
die gewünschten Daten an den Empfänger überträgt und diese
auf dem Monitor sichtbar werden.

Der Erfindung liegt die Aufgabe zugrunde, eine Fernbedienung
für fernbediente Geräte mit einer Vielzahl von Funktionen so
zu gestalten, daß mit einer minimalen übersichtlichen
Anordnung von Tasten, Sensoren oder Stellgliedern die
Funktionen gesteuert werden können, ohne daß Doppeltastensätze für Funktionssteuerungen gleichen Inhalts
(+ oder -) notwendig sind, wobei gleichzeitig ein
erweiterter späterer Einsatz für die Fernsteuerung
zusätzlicher Funktionen bei gleichem System ermöglicht
werden soll, und daß gewisse Signalverarbeitungen, die
normalerweise in dem zu steuernden Gerät vorgenommen werden,
bereits im Fernbedienungsteil vorgenommen werden können, um
dem Gerät einen vergleichsweise einfach strukturierten
Befehl geben zu können, ohne daß aufwendige Schaltungen zur
Aufarbeitung der empfangenen Signale notwendig sind. Ferner
soll gewährleistet sein, daß das Gerät auch bei Nichtbenutzung der Fernbedienung einstellbar ist und bei
Benutzung der Fernbedienung entsprechend dem eingestellten
Zustand in der Fernbedienung eingeschaltet wird.

Die Aufgabe wird erfindungsgemäß nach der im Anspruch 1
wiedergegebenen Lehre gelöst.

Vorteilhafte Weiterbildungen der Erfindung sind in den
Unteransprüchen beschrieben.

Ein wesentlicher Vorteil der Erfindung besteht darin, daß
die Fernbedienung die Steuerung einer Vielzahl von
Funktionen ermöglicht. Die Erfindung gestattet den
erweiterten Einsatz von Fernbedienungen, da sie in Verbindung
mit einem einlesbaren Datenträger praktisch eine nahezu
unbegrenzte Anzahl von Funktionssteuerungen ermöglicht, so
daß die Fernbedienung zu einem universellen Bedienkörper
wird. Wird z.B. ein Codierschlüssel als Datenträger in
einen vorgesehenen Schlitz der Fernbedienung eingeführt,
so werden entsprechend der gegebenen Codierung die
Funktionsgeneratoren aktiviert und an die Funktionssteller
angeschaltet. Wird anstelle eines Codierschlüssels ein
magnetischer Datenträger eingeführt, so sind durch Abtastung mittels eines internen elektronischen Lesers
verschiedene Festfunktionen steuerbar, bevor die
individuelle Einstellung über Funktionstasten erfolgt.

Ein weiterer Vorteil der Erfindung liegt darin, daß der
Fernbedienungsgeber eine komplexe Einheit darstellt, die in
vielfältiger Weise programmierbar und nutzbar ist, da der
Computer als zentrale Recheneinheit alle Funktionen, die in
irgendeiner Weise steuerbar sind, programmgemäß durch
Decodierung der eingegebenen Befehle bewerkstelligen kann,
und daß die abgegebenen Mehrbitinformationen pulsecode-,
amplituden- oder frequenzmoduliert übertragen werden können.
Bei leitungsloser Übertragung ist es möglich, die Fernbedienung auch vom Standort des zu steuernden nachrichtentechnischen Gerätes unabhängig zu betätigen, z.B. als
Rechner, wobei nach Anspruch 4 eine Sichtanzeige vorgesehen
ist, die die entsprechenden Endergebnisse anzeigt. Bei
Umschaltung des Fernbedienungsgebers auf ein Programm zur
Bedienung eines nachrichtentechnischen Gerätes kann selbstverständlich dieselbe Sichtanzeige zur Anzeige der
Einstellwerte verwendet werden.

Durch die serielle Eingabe der Einstellinformation über
eine Codierstufe in den Computer ist eine optimale Anpassung
und Ausnutzung der verfügbaren Eingänge gegeben. So ist es
z.B. möglich, sämtliche Funktionen seriell einzulesen,
wobei die übrigen Eingänge für nicht seriell einlesbare
Größen verwendet werden können. Im Ausführungsbeispiel, das
später beschrieben wird, ist z.B. eine manuelle Sendereeinstellung vorgesehen, bei der von einem Analogdigitalwandler
Impulse in Drehrichtung des betätigten Bedienknopfes über
zwei Leitungen eingespeist werden. Der Computer verarbeitet
nach einem vorbestimmten eingeschriebenen Programm die
eingehenden Signale und gibt ausgangsseitig eine

- 6 -

Mehrbitstellinformation über einen Datenbus an die Sendestufe
der Fernbedienungseinheit ab. Parallel dazu erfolgt die
Adressierung, d.h. es wird auch ein Adresswort der Mehrbitstellinformation zugeordnet der Sendestufe zugeleitet. Die
Sendestufe ermöglicht eine amplituden- oder frequenzmodulierte Übertragung auf drahtgebundenem oder drahtlosem Wege
zu der Empfängerschaltung in dem zu steuernden nachrichtentechnischen Gerät, z.B. ein Fernsehgerät. In Verbindung mit
letzterem ist es z.B. auch möglich, daß die Sichtanzeige,
z.B. von Rechenoperationen, durch den Bildschirm erfolgt,
indem über die Empfängerstufe entsprechende Funktionssteller
zum Anzeigen der eingegebenen und errechneten Werte angesteuert werden, welches über die Adresse erfolgt.

Die Vielseitigkeit in der Anwendung ist durch den Programmierteil des Computers gegeben, der durch ein Datenlesegerät mit
Daten versorgt wird, die den Funktionstasten bestimmte
Funktionssteuerungen zuordnen. Damit bei Wiederinbetriebsetzung der Fernbedienung die Stellinformationen augenblicklich an die zu steuernden nachrichtentechnischen Geräte
eingegeben werden können, ohne daß von einer Grundstellung
aus die Werte eingestellt werden müssen, ist es besonders
vorteilhaft, gemäß Anspruch 8 die Mehrbitstellinformationen
parallel in einem nichtflüchtigen Speicher zu speichern,
der bei Einschalten des Gerätes vom Computer abgefragt wird
und dessen Stellungen sofort als Stellinformationen an das
nachrichtentechnische Gerät übertragen werden.

Durch die Anwendung einer programmierbaren Dateneingabe
können durch Datenträger Funktionen eingelesen werden,
die ein Fernsehgerät sofort an einen Zentralcomputer
(Teletext und Viewdata) anschalten, weil beim Einführen
des Datenträgers bereits sämtliche Grundfunktionen zum
Anschalten eines externen Datengerätes an das Fernsehgerät

...übertragen werden, so daß lediglich die individuelle Abfragung von Daten über die Funktionstasten noch erfolgen muß.

In Verbindung mit der Steuerung eines Hörrundfunkgerätes weist eine nach der Erfindung ausgebildete Fernbedienung auch Vorteile für sehbehinderte Bedienende auf, da die Funktionssteuerung nur noch über wenige Funktionstasten erfolgt, aber die Vielzahl der Funktionen dennoch über den Vorwähler, den Datenträger, die Datenkarte oder den Datenschlüssel eingestellt werden kann, wobei die Vorwähler abtastbare Kennzeichen aufweisen, die eine einfache Handhabe durch den Behinderten gewährleisten.

Die Erfindung wird nachfolgend anhand der in den Fig. dargestellten Ausführungsbeispiele näher erläutert.

In den Zeichnungen zeigen

Fig. 1 einen Fernbedienungsgeber mit einem von Datenträgern einlesbaren Funktionsvorwähler, wobei auf der Fernbedienung eine Zehnertastatur und mindestens zwei zusätzliche Funktionstasten vorgesehen sind,

Fig. 2 ein Blockschaltbild des Sender- und Empfängerteils einer erfindungsgemäß ausgebildeten Fernsteuerung,

Fig. 3 ein Blockschaltbild einer Fernbedienung mit Computer,

Fig. 4 eine Empfängerschaltung für eine Fernbedienung nach Fig. 3 und

- 8 -

Fig. 5 eine Sichtanzeige in einer Fernbedienung
mit einem Computer nach Fig. 3.

In Fig. 1 ist ein erfindungsgemäß ausgebildeter Fernbedienungsgeber dargestellt, bei dem die zu stellenden
Funktionen über Datenträger 3a/3b eingelesen werden.
Diese Datenträger können aus Codierschlüsseln oder Magnetkarten bestehen. Sie sind äußerlich in Form und Farbgestaltung so geschaltet oder beschriftet, daß ein visueller
oder fühlbarer Unterschied gegeben ist, wodurch die entsprechend zu wählende Funktionsdatenträgerkarte einfach
aufzufinden ist. Der Datenträger 3a/3b wird in einen
Schlitz oder in eine Ausnehmung 4 des Fernbedienungsgebers
eingeführt und mittels elektronischer oder mechanischer
Abtastung abgefragt. Die der zu steuernden Funktion zugeordneten Funktionstasten 5 der Zehnertastatur sind über
einen vom Datenträger aktivierten Umschalter direkt oder
über einen zwischengeschalteten vom Datenträger programmierten Computer bzw. Microprozessor an die Funktionsgeneratoren
angeschaltet. Bei Verwendung eines magnetischen Datenträgers
ist der Vorteil gegeben, daß Festprogramme speicherbar sind,
wodurch die Funktionsgeneratoren Festdaten übertragen können,
die, bevor die einzelnen Funktionstasten betätigt werden,
bereits Funktionen im Empfängerteil steuern. Dies ist z.B.
von Vorteil bei der Verwendung eines Fernsehgerätes in
Verbindung mit Bildschirmtexten, z.V. Viewdata oder Teletext,
bei der Einschaltvorgänge bestimmter Funktionen nacheinander
vollzogen werden müssen, um den externen Datenspeicher an
das Fernsehgerät anzuschließen. Ist der Fernbedienungsgeber
durch Einlesen des Datengebers vorbereitet, so können die
Funktionstasten entsprechend ihrer Zuordnung betätigt
werden. Die Zehnertastatur läßt sich z.B. auch bei Geräten
mit Abstimmeinrichtungen nach der Frequenzsynthese einsetzen,
wobei die Frequenzen über die Zehnertastatur fest eingegeben
werden können.

Parallel dazu sind bei Funktionsumschaltung gespeicherte
Festsender sowie Daten vom externen Datenträger abfragbar.
Zusätzlich zu der Zehnertastatur können selbstverständlich
auch Funktionstasten für die Regelung variabler Größen mit
+ und - vorgesehen werden bzw. Tasten für die Auslösung von
Rechenoperationen, wenn der Fernbedienungsgeber als Rechner
bzw. Rechnertastatur benutzt wird.

Es ist ersichtlich, daß eine Fernbedienung nach dem in Fig. 1
dargestellten Ausführungsbeispiel universell einsetzbar ist,
da lediglich entsprechend der zu steuernden Funktion unterschiedliche Datenträger eingegeben werden müssen, vorausgesetzt, daß die ferngesteuerten Geräte gleiche Fernbedienungssysteme aufweisen. Mit ein und derselben Fernbedienung ist es somit möglich, verschiedene Geräte zu steuern,
die sich in einem Raum oder aber auch bei drahtgebundener
Fernübertragung außerhalb des Raumen befinden.

In Fig. 2 ist in einem Blockschaltbild der Basisschaltungsaufbau einer Fernbedienung dargestellt. Im linken Teil ist
der Fernbedienungsgeber und im rechten Teil der Empfänger
dargestellt. Als Übertragungsmedium ist Infrarotlicht vorgesehen. Der Funktionsvorwähler 6 wird durch einen Drehschalter 1 bzw. den Datenträger 3 eingestellt, so daß bestimmte Funktionen mit den Tasten 8 des Tastenfeldes
gesteuert werden können. Über den Funktionsvorwähler 6
werden Funktionsgeneratoren 9 bei Betätigung der Funktionstasten 8 des Tastenfeldes eingeschaltet, deren Ausgangssignale über eine Sendestufe 10 einem Infrarotlichtgeber 11
zugeführt werden, der die Befehle frequenzmoduliert überträgt. Die Funktionsgeneratoren 9 können aus einem einzigen
Funktionsgenerator bestehen, der bei digitaler Übertragung
unterschiedliche Impulsfolgen entsprechend der zu
steuernden Funktion bzw. codierte Wörter aussendet, die
den Infrarotlichtgeber 11 tasten. Es können aber auch unterschiedliche Trägerfrequenzen ausgesendet werden.
Die empfangenen Infrarotlichtsignale werden mit der
Fotodiode 12 aufgefangen und in einem Vorverstärker
verstärkt und in einem nachgeschalteten Demodulator
demoduliert bzw. in der integrierten Decodierstufe
decodiert. Die Steuerbefehle bewirken zunächst, daß
der elektronische Umschalter 14 die Signalleitung an
den zu steuernden Funktionssteller 15 umschaltet, so
daß die Funktion  entweder direkt oder nach zwischenzeitlicher Umwandlung der Befehlssignale in einen
entsprechenden Analogwert auf die geänderte Größe
eingestellt wird. Dem elektronischen Umschalter 14
kann aber auch ein Microprozessor bzw. Microcomputer
vorgeschaltet werden, über den bestimmte errechnete
programmierbare Funktionswerte erhalten werden, die
zur Steuerung einzelner Funktionen verwendet bzw. auf
einem Monitor angezeigt werden.

In den Fig. 3 bis 5 sind ein Fernbedienungsgeber und ein
Fernbedienungsempfänger für ein Fernsehempfangsgerät dargestellt. Die mit 21 bezifferte Tastatur stellt die
Eingabetastatur der Fernbedienung dar. Sie ist über eine
Matrixschaltung 27 mit einer Codierschaltung 28 verbunden.
Bei Betätigen der einzelnen Bedienorgane erfolgt eine
Matrizierung. Das Ausgangssignal wird von der Codierschaltung 28 in einen Mehrbitbefehle umgewandelt, der über den
Eingang C in den Computer eingeschrieben wird. Der
Computer 22 arbeitet nach einem bestimmten Programm, das
vom Datenlesegerät 30 vom Datenträger 31 ausgelesen und
eingeschrieben wurde. Nach dem vorgegebenen Programm
werden die einzelnen Steuerbefehle in dem Computer 22
verarbeitet. Paralleleingänge zu C sind ferner vorgesehen
für die Verarbeitung von Signalen von einem manuell
betätigbaren Abstimmkreis, der aus einem Abstimmknopf 35 besteht, der sowohl in Links- als auch Rechtsdrehung
entsprechend zugeordnete Impulse erzeugt, die in einer
nachgeschalteten Codierstufe 36 in eine Mehrbitinformation
umgewandelt werden, die entsprechend der Drehrichtung des
Abstimmknopfes 35 über den einen oder anderen Eingang des
Computers eingelesen werden. Dasselbe kann auch bei elektronischem Suchlauf erfolgen, wozu weitere Eingänge zu
belegen sind bzw. durch Betätigung zweier Tasten im Bedienfeld ebenfalls bewerkstelligt werden kann. Die Energieversorgung des Computers 22 erfolgt von der Spannungsquelle
37 aus. Der Computer verarbeitet die eingehenden Mehrbitinformationen nach dem eingeschriebenen Programm und gibt
am Ausgang A die einem jeden Steuerbefehl zugeordnete
Adresse aus und über den Ausgang B die Mehrbitstellinformation,
die eine bestimmte Steuerung eines adressierten Funktionsstellers bewirken soll. Der Adressbus sowie der Datenbus
sind mit der Sendestufe 23 verbunden, die die anliegenden
Mehrbitinformationen mit einem Träger amplituden- oder
frequenzmoduliert. In der Ausführung wurde als Träger
Infrarotlicht gewählt, das von der Fotodiode 32 ausgesendet
und von der Empfangsfotodiode 33 empfangen wird. Die Sendestufe 23 selbst besteht aus mehreren oder einem abstufbaren
Funktionsgenerator, der entsprechend den anliegenden Mehrbitinformationen getaktet wird und dessen Ausgangssignale
eine HF-Stufe steuern, die die Fotodiode 32 ansteuert.
Die durch die Fotodiode 33 empfangenen Signale werden in
einer Empfangsstufe 24 demoduliert und entsprechend Adresse
und Mehrbitstellinformation einem Adressbus 38 und einem
Datenbus 39 zugeführt. Der Adressbus 38 endet in einem
Adressdecoder 25, der eine Vielzahl von Ausgängen aufweist,
von denen ein adressierter freigeschaltet wird, der mit dem
neu einzustellenden Funktionssteller verbunden ist.

- 12 -

Gleichzeitig liegt die Mehrbitstellinformation an dem
freigegebenen Funktionssteller (26a bis 26d), so daß der
von einem Generator 40 abgegebene Setzimpuls (Strobe-Impuls)
den Funktionssteller, der angesteuert werden soll, setzen
kann. Ist dies erfolgt, so bleibt die in den Funktionssteller eingespeicherte Stellgröße erhalten und der
entsprechend eingestellte Funktionswert ist sichtbar,
hörbar oder in einer anderen Weise erkennbar.

In Fig. 5 ist eine Ergänzung zum Fernbedienungsgeber
nach Fig. 3 vorgesehen, indem an den Ausgängen A und B
des Computers zusätzlich zur Sendestufe 23 eine Sichtanzeige 34 angeschlossen ist, die aus einem Speicherbaustein
mit entsprechend angesteuerten Sichtanzeigen besteht.
Bei Anliegen einer Adresse, die eine zugeordnete Sichtanzeige adressiert, wird die über den Datenbus B anliegende
Mehrbitstellinformation in der Sichtanzeige ebenfalls
gespeichert und angezeigt. Dadurch kann der Bedienende,
ohne daß sichtbare Mittel am Fernsehgerät vorgesehen sind,
jede optische, akustische oder sonstige Einstellung anhand
der Sichtanzeigen überprüfen.

Bei dem ausgeführten Beispiel ist vorgesehen, daß der
Computer 22 als Stellorgan arbeitet. Er kann ebensogut
auch die Zählerstände der mit dem Bedienorgan verbundenen
Zähler eines anderen Systems abfragen und die Zählerstände
als Einstellinformation verarbeiten.

Eine weitere Variante ist gegeben durch die Anwendung
verschiedenster Datenträger zur Einschreibung verschiedenster Programme, so daß bei gegebener Zehnertastatur auf
dem Bedienfeld der Fernbedienung und unter Zugrundelegung
verschiedener anderer Funktionstasten eine vollwertiger
Rechner mit der Fernbedienung realisierbar ist.

Die Erfindung weist gegenüber bekannten Fernbedienungsverfahren den Vorteil auf, daß die Steuerbefehle als
Digitalgrößen übertragen werden, keine Signalaufarbeitung
in dem entfernten fernzusteuernden Gerät erfolgt und damit
auf dem Übertragungswege eine optimale Sicherheit gegeben
ist. Wenn die einzelnen Befehle unausgewertet übertragen
werden, so ist es nicht ausgeschlossen, daß durch Einstrahlung in das Übertragungsmedium Verfälschungen und
Fehlanzeigen erfolgen. Durch die Verwendung von Stellgrößen,
die dann frequenz- und/oder amplitudenmoduliert übertragen
werden, sind Fehler dieser Art fast völlig ausgeschaltet.

Bei Eingabe eines Uhr/Datum-Programms kann die Fernbedienung als Uhr verwendet werden und bei Erweiterung
auch als Schaltuhr zum Ein- und Ausschalten des nachrichtentechnischen Gerätes. Die Anzeige ist dabei entweder in der
Fernbedienung selbst möglich oder auf dem Bildschirm eines
gesteuerten Fernsehgerätes. Für die Übertragung der Daten
können alle bekannten Träger, wie Ultraschall, Infrarotlicht,
elektromagnetische Wellen, eingesetzt werden. Die Sende-
und Empfängerstufe ist jeweils dem gewählten Träger anzupassen.

0002434

- 1 -.

Patentansprüche:

1. Fernsteuerung zum Steuern, Ein- und Umschalten von
variablen und festen Gerätefunktionen und Funktionsgrößen
in nachrichtentechnischen Geräten, insbesondere Geräten
der Unterhaltungselektronik, mit einem Fernbedienungsgeber mit Funktionstasten und/oder Analogwertstellern,
über die bei Betätigung Funktionsgeneratoren eingeschaltet werden, deren die Steuerbefehle beinhaltenden
Ausgangssignale drahtlos oder drahtgebunden vom Fernbedienungsgeber zum Empfänger des zu steuernden Gerätes
frequenz- oder amplitudenmoduliert übertragen werden,
d a d u r c h   g e k e n n z e i c h n e t, daß die
Funktionsgeneratoren über einen im Fernbedienungsgeber
eingebauten Computer (22.) angesteuert werden, in den bei
Betätigung der Funktionssteuertasten (21) und/oder der
Analogwertsteller der Betätigungszeit bzw. der Einstellung
proportionale  Steuerbefehle direkt geschrieben oder in
einem elektronischen Digitalzähler gespeichert werden, der
von dem Computer (22) zyklisch abgefragt wird, und daß der
Computer (22) nach bestimmten eingeschriebenen Programmen
eine Decodierung und Auf- bzw. Umrechnung des Steuerbefehls
vornimmt und eine den jeweiligen Steuerbefehl beinhaltende
Mehrbitstellinformation über einen Datenbus (B, Fig. 4) an
die Funktionsgeneratoren der Sendestufe (23) abgibt, und
daß parallel oder seriell vom Computer (22) eine Adresse
als Mehrbitinformation über einen Adressbus (A, Fig. 4)
ebenfalls an die Sendestufe (23) gegeben wird, die die
anliegenden Mehrbitstellinformationen parallel oder
seriell mit einem Träger frequenz- oder amplitudenmoduliert,
leitungslose oder leitungsgebunden an eine Empfängerschaltung (24) sendet, die nach Demodulation der Eingangssignale die Adresse über einen Adressbus an einen
Adressdecoder (25), über welchen die zu stellenden

Funktionssteller (26a, 26b, 26c, 26d) gesetzt werden und die Mehrbitstellinformationen über einen Datenbus an die Eingänge der Funktionssteller (26a bis 26d) leitet, und daß derjenige Funktionssteller (26a bis 26d) von der anliegenden Mehrbitstellinformation gesteuert wird, der adressiert ist, wobei über den Adressdecoder (25) ein Setzimpuls an den adressierten Funktionssteller gelegt wird.

2. Fernsteuerung nach Anspruch 1, d a d u r c h   g e - k e n n z e i c h n e t, daß die bei Betätigung der Bedienorgane erzeugten Steuerimpulse in einer Matrixschaltung (27) matriziert und in einer nachgeschalteten Codierschaltung (28) codiert werden, und daß die Mehrbitinformationen seriell über einen Eingang (C, Fig. 4) in den Computer (22) eingeschrieben werden, und daß weitere Eingänge des Computers mit weiteren Bedienorganen verbunden sind, und daß die einzelnen Mehrbitinformationen in dem Computer nach eingeschriebenen Programmen decodiert und nach Aufrechnung als Mehrbitstellinformation sowohl in einem nichtflüchtigen Speicher (29) gespeichert als auch über einen Adress- und einen Datenbus an die Sendestufe (23) des Fernbedienungsgebers gelegt werden.

3. Fernsteuerung nach Anspruch 1 oder 2, d a d u r c h   g e k e n n z e i c h n e t, daß der Computer (22) mit einem Datenlesegerät (30) verbunden ist, in das ein Datenträger (31) einführbar ist, auf dem ein festes Programm, Rechengrößen und dergl. gespeichert sind, die vom Datenlesegerät (30) ausgelesen und in den Computer (22) eingeschrieben werden, und daß der Computer (22) die von dem Bedienteil eingegebenen Signale nach dem

- 3 -

vorgegebenen Programm decodiert, umsetzt und aufrechnet, und daß die im Rechenprogramm errechneten Mehrstellinformationen über den Datenbus und die zugehörige Adresse über den Adressbus an die Sendestufe (23) übertragen werden, die die Signale auf einen Träger frequenz- oder amplitudenmoduliert aussendet, die von der Empfängerschaltung empfangenen demoduliert und den anzusteuernden Funktionsstellern Anzeigemittel und dergl. zugeführt werden.

4. Fernsteuerung nach einem der vorhergehenden Ansprüche, d a d u r c h   g e k e n n z e i c h n e t, daß die Mehrbitstellinformation in einer adressierten Sichtanzeige (34) angezeigt wird.

5. Fernsteuerung nach einem der vorhergehenden Ansprüche in Verbindung mit einem Datensichtgerät, d a d u r c h   g e k e n n z e i c h n e t, daß auf dem Datensichtgerät eine numerische Anzeige der Einzelfunktionen und deren Wertigkeit erfolgt.

Europäisches
Patentamt

**EUROPÄISCHER RECHERCHENBERICHT**

0002434

Nummer der Anmeldung

EP 78 10 0948

| | EINSCHLÄGIGE DOKUMENTE | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | |
| | IEEE TRANSACTIONS ON NUCLEAR SCIENCE, Jahrgang NS-20, Nr. 3, Juni 1973, New York (US) HARTWAY "A compact programmable control panel for computer control systems", Seiten 531 bis 535 <br><br> * Seite 531, Abschnitte "Summary" und "Introduction"; Figuren 1,4, 6,7 * <br><br> -- | 1,3 | H 03 J 1/18 <br> G 08 C 23/00// <br> G 06 F 3/02 |
| | WESTERN ELECTRIC TECHNICAL DIGEST Nr. 35, Juli 1974, New York, US L.A. SOLOMON "Wisdom 1", Seiten 51,52 <br><br> * Vollständig * <br><br> -- | 1,3 | RECHERCHIERTE SACHGEBIETE (Int. Cl.³) <br><br> H 03 J 1/18 <br> G 08 C 23/00 <br> G 06 F 3/02 |
| | IBM TECHNICAL DISCLOSURE BULLETIN, Jahrgang 10, Nr. 7, Dezember 1967, New York (US), DAVIS et al. "Polarized mode selector", Seiten 888,889 <br><br> * Vollständig * <br><br> -- | 1,3 | |
| | DE - A - 2 542 021 (PHILIPS) <br><br> * Seite 6, letzter Absatz bis Seite 9, erster Absatz; Figur 1 * <br><br> -- | 1,2 | KATEGORIE DER GENANNTEN DOKUMENTE <br><br> X: von besonderer Bedeutung <br> A: technologischer Hintergrund <br> O: nichtschriftliche Offenbarung <br> P: Zwischenliteratur |
| P | DE - A - 2 625 131 (DEUTSCHE ITT) <br><br> * Patentanspruch; Figur * <br><br> -- <br><br> ./. | 1,2 | T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patentfamilie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 13-12-1978 | THOMAS |

EPA form 1503.1 06.78

0.02434

| EINSCHLÄGIGE DOKUMENTE | | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| | FUNKSCHAU, Jahrgang 49, Nr. 6, März 1977, München (DE) P. WAHL "Farbportable mit Ultra-schall-Fernbedienung", Seiten 249 bis 252 <br> * Seite 250, Bild 3 * <br> --- | 1,2 | |
| | ELECTRONIC ENGINEERING, Jahrgang 48, Nr. 578, April 1976, London (GB) FADRHONS "Frequency synthesiser tuning with shaft encoder", Seiten 27,28 <br> * Vollständig * <br> --- | 2 | |
| | IEEE TRANSACTIONS ON CONSUMER ELECTRONICS, Jahrgang CE-22, Nr. 4, November 1976, New York (US) EVANS et al. "Direct address tele-vision tuning and display system using digital MOS large scale inte-gration", Seiten 267 bis 287 <br> * Seite 279, Abschnitt 1 "Remote transmitter"; Seite 284, Ab-schnitt ."7. Clock and display system"; Figuren 13,18 * <br> --- | 1,5 | RECHERCHIERTE SACHGEBIETE (Int. Cl.²) |
| A | DE - A - 2 346 262 (NORDDEUTSCHE MENDE RUNDFUNK KG) <br> * Patentanspruch 1; Bild 2 * <br> --- | 1 | |
| | DE - A - 2 612 260 (NORDDEUTSCHE MENDE RUNDFUNK KG) <br> ./. | 1,4 | |

0002434

EUROPÄISCHER RECHERCHENBERICHT

Europäisches Patentamt

Nummer der Anmeldung

EP 78 10 0948
-3-

| EINSCHLÄGIGE DOKUMENTE | | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| | * Seite 3, Abschnitt "Erläuterung der Erfindung"; Abbildung * | | |
| P | FUNKSCHAU, Jahrgang 50, Nr. 8, April 1978 KARNATZKI "Infrarot-Fernbedienung mit 1024 Befehlen", Seiten 323-326 * Seite 324, rechte Spalte, Abschnitt "Die Sender IS SAA 1050"; Bild 5 * | 1,2,5 | |
| | | | RECHERCHIERTE SACHGEBIETE (Int. Cl.²) |

EPA Form 1503.2  06.78